# EUROPEAN PATENT APPLICATION

(11) **EP 1 128 423 A2**
(43) Date of publication of application: **29.08.2001**
(21) Application number: 01400488.1
(22) Date of filing: 23.02.2001
(51) Int. Cl.: H01L 21/60, H01L 23/485

(54) **Flip-Chip mounted electronic device with multi-layer electrodes**

(30) Priority: 25.02.2000 JP 2000049445; 22.01.2001 JP 2001013514
(71) Applicant: Murata Manufacturing Co., Ltd., Nagaokakyo-shi Kyoto-fu 617-8555 (JP)
(72) Inventor: Taga, Shigeto, c/o (A170) I. Property Department, Nagaokakyo-shi, Kyoto-fu 617-8555 (JP)
(74) Representative: Joly, Jean-Jacques

(57) **Abstract**

An electronic element (2) adapted for a facedown mounting, includes a substrate (3), an electrode provided on the substrate, an electrode pad (6-8) connected to the electrode, an upper electrode (11) disposed on the electrode pad and connected to a metallic bump (10), and an intermediate electrode (12) located between the electrode pad (6-8) and the upper electrode (11). The intermediate electrode (12) preferably includes a single layer made of a metal other than a metal constituting the electrode pad or the upper electrode, and a thickness thereof exceeds approximately 50 nm.

## Description

### BACKGROUND OF THE INVENTION

### 1. Field of the Invention

The present invention relates to a structure of an electronic element suitable for facedown mounting wherein a metallic bump provided on a substrate of an electronic element is connected by being mounted to a package made of a ceramics material or other suitable material, or by being mounted to an electrode pattern of a circuit substrate or other suitable substrate.

### 2. Description of the Related Art

In recent years, electronic apparatuses have become compact and low-profile. In addition, instead of using the conventional connection method using a lead wire, a facedown mounting method for connecting an electrode pad of an electronic element and an electrode pattern of a package has been developed. In the facedown mounting method, a functional surface of the electronic element is arranged to face a connection surface of the package and is directly mounted thereon.

In order to secure the connection of an electrode pad of an electronic element and an electrode pattern of a package using the facedown mounting method, a solder bump has been frequently used because of the ease of connection achieved thereby. Some problems occurred, however, in that the solder bump spread out along the electrode pads of electronic elements and electrode patterns of packages due to a material property thereof. Furthermore, solder bumps must be formed by a printing method which makes it difficult to form small solder bumps or by a plating method which requires a long process time to form the bumps.

Therefore, use of metallic bumps such as an Au bump has been researched. A width of the solder bump was about 500 µm. On the other hand, metallic bumps such as an Au bump can be formed to be about 100 µm in width using an Au wire, so that the metallic bumps are suitable for miniaturizing electronic component apparatuses.

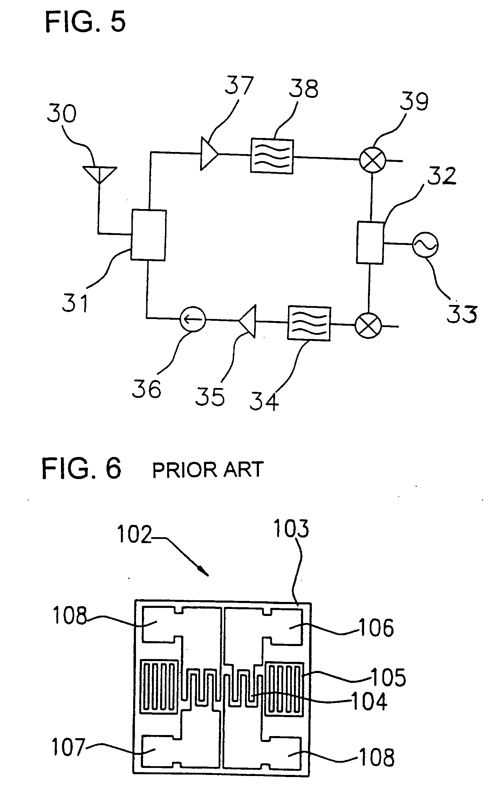

A general constitution of a surface acoustic wave apparatus, as an example of electronic component apparatuses adapted to use a facedown mounting method using the aforementioned metallic bump, will be explained with reference to Figs. 6 to 8.

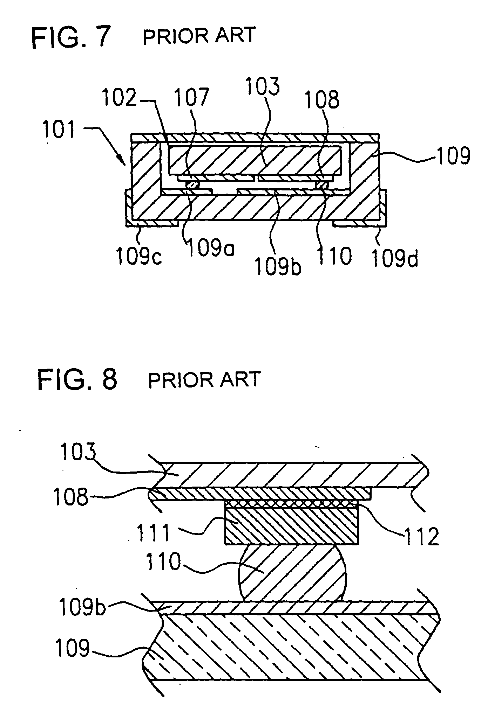

Fig. 6 is a plan view of a surface acoustic wave element used for a surface acoustic wave apparatus. Fig. 7 is a sectional view of a surface acoustic wave apparatus in which this surface acoustic wave element is put in a package. Fig. 8 is an enlarged sectional view of a connecting portion of an electrode pad part of the surface acoustic wave element and a pattern electrode of the package with a metallic bump disposed therebetween.

As shown in Fig. 6, a surface acoustic wave element 102 is composed of a piezoelectric substrate 103 and an [DT 104, a reflector 105, an input electrode 106, an output electrode 107, and ground electrodes 108, which are formed of a conductive thin film containing A1 as a primary component. on the piezoelectric substrate 103. Among these electrodes, the IDT 104 and the reflector 105 are element electrodes for functions of the surface acoustic wave element 102, and the input electrode 106, the output electrode 107, and the ground electrodes 108 are electrode pads to be connected to a circuit substrate and a package.

As shown in Fig. 7, in a surface acoustic wave apparatus 101, a surface acoustic wave element 102 is mounted facedown in a package 109. Theoutput electrode 107 and an electrode pattern 109a disposed on the package 109, and one ground electrode 108 and an electrode pattern 109b disposed on the package 109 are connected, respectively, by Au bumps 110. Although not shown in the drawings, the input electrode 106 and the other ground electrode 108 are also connected to electrode patterns provided on the package 109 via Au bumps 110. The reference numerals 109c and 109d indicate external electrodes connected to electrode patterns 109a and 109b, respectively.

Each electrode 104 to 108 disposed on the piezoelectric substrate 103 is formed by producing a metallic thin film about 0.1 µm to 0.2 µm in film thickness containing Al as a primary component using a vapor deposition method or a sputtering method on the piezoelectric substrate 103, and thereafter, patterning the thin film into a predetermined shape by photolithography and etching. Since each electrode is formed at the same time using vapor deposition, etc., as described above, film thicknesses of the input electrode 106, the output electrode 107, and the ground electrodes 108 being electrode pads are determined based on a film thickness of the IDT 104. That is, in the case in which the film thickness of the IDT 104 has to be about 0.1 µm to 0.2 µm, the thicknesses of the electrode pads cannot exceed the aforementioned thickness of the IDT. Therefore, when the Au bump is formed directly on the aforementioned electrode pad about 0.1 µm to 0.2 µm in thickness, and the surface acoustic wave element 102 is mounted facedown on the package 109 with the Au bump therebetween, the strength of electrode pad parts is decreased so that, for example, electrode pads peel off, and therefore sufficient connection strength cannot be achieved.

As shown in Fig. 8, in the conventional surface acoustic wave element 102, an upper electrode 111 about 1 µm in thickness made of a metal containing Al as a primary component was further provided using vapor deposition or sputtering on the ground electrode 108 being the electrode pad formed on the piezoelectric substrate 103, and therefore the thickness of the electrode pad was secured so as to realize sufficient connection strength. Furthermore, although not shown in the drawings, upper electrodes 111 are also formed on the input electrode 106 and the output electrode 107 in a manner similar to that of the ground electrode 108. Since the input electrode 106, the output electrode 107, and the ground electrodes 108 are composed of a metal containing Al as a primary component, surfaces of these electrodes are likely to be oxidized. When the upper electrodes 111 made of Al being the same as the aforementioned Al are provided directly on the input electrode 106, the output electrode 107, and the ground electrodes 108 having oxidized surfaces, sufficient adhesion strength cannot be realized. Therefore, intermediate electrodes 112, for example Ti, having superior connection strength with Al were provided between the upper electrodes 111 and the input electrode 106, the output electrode 107, and the ground electrodes 108 to realize sufficient adhesion strength.

Regarding such a conventional surface acoustic wave element, there was, however, a problem as described below. That is, in the case in which the surface acoustic wave element is arranged to face an electrode pattern disposed on the package with the Au bump therebetween, and pressure is applied while an ultrasonic wave or heat is applied so as to connect the electrode pattern and the Au bump, a large stress is applied to a portion of the surface acoustic wave element attached to the Au bump. That is, a large stress is applied to the input electrode, the output electrode, the ground electrodes, and the upper electrodes formed thereon.

When a thermal stress or a mechanical stress is applied during the assembling processes such as an airtight sealing process, etc., or when another external shock or a thermal stress due to a change in environmental temperature is applied, a large external force is also applied to the input electrode, the output electrode, the ground electrodes, and the upper electrodes formed thereon.

In the conventional surface acoustic wave element, since the intermediate electrodes, for example, made of Ti, having superior connection strength with Al, were provided between the upper electrodes and the input electrode, the output electrode, and the ground electrodes so as to increase connection strength, the stress was concentrated not at the connection part of the intermediate electrode, but at the piezoelectric substrate. Consequently, there was a problem in that cracks and fractures occurred in the piezoelectric substrate. It was found that the cracks and fractures in the piezoelectric substrate would cause problems, for example, damage to elements, decrease in connection strength, and disconnection of electrical continuity, so that functions of a surface acoustic wave apparatus were degraded.

The cracks and fractures in the piezoelectric substrate are caused by the various stresses applied to the piezoelectric substrate during the face-down mounting process, a sealing process, and other related processes. It has been confirmed by the inventor of the present invention that, even when various parameters used in the face-down mounting process such as power and the duration of application of ultrasonic waves, a heating temperature, or an amount of a pressing weight and parameters used in the sealing process such as a heating temperature, a heating duration, dimensions of electrodes are optimized so as to reduce the occurrence of the cracks and fractures, it is impossible to prevent the cracks in the piezoelectric substrate and ensure the sufficient connection strength between the electrodes and the bumps.

### SUMMARY OF THE INVENTION

In order to overcome the problems described above, preferred embodiments of the present invention provide an electronic element, wherein in the case in which an electronic element is facing an electrode pattern provided on a package or a circuit substrate with an Au bump therebetween, and pressure is applied while an ultrasonic wave or heat is applied so as to connect the electrode pattern and the Au bump, even when a large stress is applied to a portion of the electronic element attached to the Au bump, problems such as cracks and fractures in an element substrate do not occur.

An electronic element according to a preferred embodiment of the present invention includes a substrate, an electrode disposed on the substrate, an electrode pad connected to the electrode, an upper electrode disposed on the electrode pad and connected to a metallic bump, and an intermediate electrode disposed between the electrode pad and the upper electrode. The intermediate electrode preferably includes a single layer made of a metal other than a metal constituting the electrode pad or the upper electrode, and a thickness of the intermediate electrode is preferably greater than about 50 nm.

The intermediate electrode may be composed of a plurality of layers made of a metal other than a metal constituting the electrode pad or the upper electrode, and a total thickness of the plurality of layers preferably exceeds approximately 50 nm.

The thickness of the aforementioned intermediate electrode or the sum of the plurality of layers is preferably about 100 nm or more. The metal constituting the aforementioned electrode pad or the aforementioned upper electrode is Al, and the aforementioned intermediate electrode is preferably one metal selected from the group consisting of Ni, Cr, NiCr, and Ti.

The aforementioned metallic bump is preferably made of Au or a metallic material containing Au as a primary component.

At least one layer of the substrate electrode may be provided between the electrode pad and the element substrate.

It is preferable that the aforementioned facedown mounting is performed using an ultrasonic wave. In addition, the electronic element is preferably a surface acoustic wave element, and the electronic element is preferably mounted in a package via a facedown mounting method.

The cracks and fractures that occurred in the substrate with conventional methods, do not occur because of the differentiation of the material of the intermediate electrode from the material of the electrode pad or the upper electrode, which disperses the stress applied to the piezoelectric substrate at boundaries with each layer of the electrode pad. the intermediate electrode, and the upper electrode during the mounting. The cracking in the piezoelectric substrate is prevented from occurring by not only differentiating the material of the intermediate electrode from the material of the electrode pad or the upper electrode. In preferred embodiments of the present invention, when the intermediate electrode is a single layer, a thickness thereof preferably exceeds about 50 nm, preferably to be about 100 nm or more, so as to prevent the cracking in the piezoelectric substrate from occurring. This is because when the thickness of the intermediate electrode is decreased, the intermediate electrode disperses into the electrode pad or the upper electrode, and therefore, the layer of the intermediate electrode disappears, and the electrode pad, the intermediate electrode, and the upper electrode are made to be one electrode pad so that the stress cannot be dispersed at the boundaries of layers.

In the electronic element in which the intermediate electrode includes a plurality of layers, when the number of the metallic layers other than the electrode pad and the upper electrode is increased, the thickness of each metallic layer may be decreased. Not all of the layers are, however, considered to disappear by this increase in the number of layers, so that the stress can be dispersed at the boundaries of the layers. Accordingly, the total thickness of the metallic layers other than the electrode pad and the upper electrode is larger than a thickness corresponding to about 50 nm, and preferably, the total thickness of metallic layers other than the electrode pad and the upper electrode is larger than about 100 nm.

The electronic element or the surface acoustic wave element may be mounted in a package container using the aforementioned mounting method, and the package container may be sealed airtight with a cap to produce an electronic component or a surface acoustic wave apparatus.

According to various preferred embodiments of the present invention, in electronic component apparatuses, since the adhesive strength between the metallic bump and the electrode pad is sufficient, and cracking and fracturing do not occur in the element substrate, damage to electronic elements and a decrease in connection strength can be prevented. Therefore, it is useful for improving yields of electronic elements and electronic part apparatuses, for decreasing failure rates, for improving reliabilities, and other characteristics thereof.

Other features, characteristics, elements and advantages of the present invention will become more apparent from the following detailed description of preferred embodiments thereof with reference to the attached drawings.

For the purpose of illustrating the invention, there is shown in the drawings several forms which are presently preferred, it being understood, however, that the invention is not limited to the precise arrangements and instrumentalities shown.

### BRIEF DESCRIPTION OF THE DRAWINGS

Fig. 1 is a plan view of a surface acoustic wave element according to a preferred embodiment of the present invention.

Fig. 2 is a sectional view of a surface acoustic wave apparatus according to a first preferred embodiment of the present invention.

Fig. 3 is an enlarged sectional view of a mounting portion joined via a metallic bump on a package of a surface acoustic wave apparatus according to a second preferred embodiment of the present invention.

Fig. 4 is an enlarged sectional view of a mounting portion joined via a metallic bump on a package of a surface acoustic wave apparatus according to a third preferred embodiment of the present invention.

Fig. 5 is a block diagram showing in part a communications apparatus according to fourth preferred embodiment of the present invention.

Fig. 6 is a plan view of a conventional surface acoustic wave element.

Fig. 7 is a sectional view of a conventional surface acoustic wave apparatus.

Fig. 8 is an enlarged sectional view of a mounting portion joined via a bump electrode on a package of the conventional surface acoustic wave element.

### DETAILED DESCRIPTION OF PREFERRED EMBODIMENTS

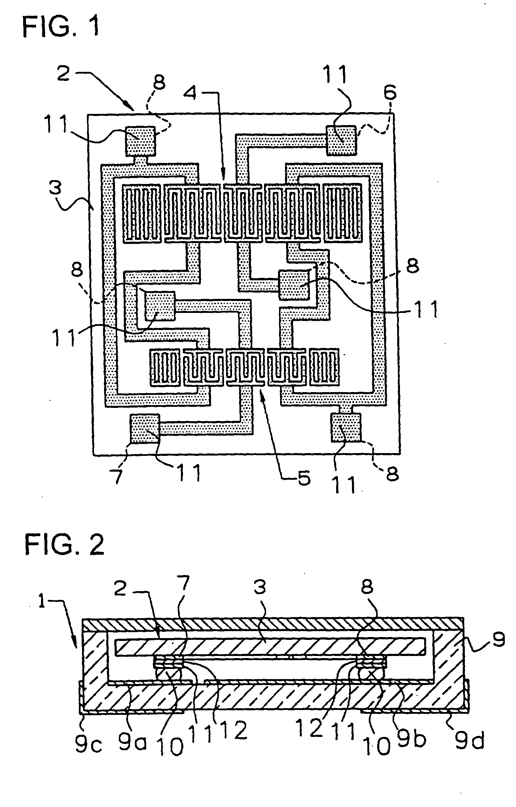

A preferred embodiment according to the present invention will be explained, with a surface acoustic wave apparatus as an example of electronic component apparatuses, with reference to Figs. 1 and 2. Fig. 1 is a plan view of a surface acoustic wave element used for a surface acoustic wave apparatus, and Fig. 2 is a sectional view of a surface acoustic wave apparatus in which a surface acoustic wave element is put in a package.

As shown in Fig. 1, a surface acoustic wave element 2 preferably includes a piezoelectric substrate 3 preferably made of lithium tantalite or other suitable material, IDTs and reflectors of two longitudinally coupled double mode surface acoustic wave filters 4 and 5 defined by a thin film of about 100 nm to about 400 nm in thickness made of Al on the piezoelectric substrate 3, and upper electrodes 11 disposed on an input electrode 6, an output electrode 7, and ground electrodes 8 with intermediate electrodes therebetween. Among these electrodes, the IDTs and reflectors of the two longitudinally coupled double mode surface acoustic wave filters 4 and 5 are element electrodes for functions of the surface acoustic wave element 2, and the input electrode 6, the output electrode 7, and the ground electrodes 8 are electrode pads for connecting to a circuit substrate and a package.

As shown in Fig. 2, a surface acoustic wave apparatus 1 is the one in which a surface acoustic wave element 2 is mounted facedown in a package 9, preferably made of a ceramics material. An upper electrode 11 having a thickness of about 1 µm, made of Al and located on the output electrode 7 with an intermediate electrode 12 made of a NiCr alloy film of about 200 nm in thickness therebetween and an electrode pattern 9a made of Au and provided on the package 9 are connected with an Au bump 10 therebetween. An upper electrode 11 about 1 µm in thickness made of Al and disposed on one ground electrode 8 with an intermediate electrode 12 made of a NiCr alloy film of about 200 nm in thickness therebetween and an electrode pattern 9b made of Au and disposed on the package 9 are connected with an Au bump 10 therebetween. Although not shown in the drawings, the input electrode 6 and another ground electrode 8 are similarly connected to an electrode pattern disposed on the package 9 with an Au bump 10 therebetween. Reference numerals 9c and 9d indicate external electrodes made of Au, and these electrodes are connected to the electrode patterns 9a and 9b, respectively. A cap of the package 9 may be made of the same ceramics material as the part for containing the surface acoustic wave element 2, or may be a metallic board.

Next, a manufacturing method for a surface acoustic wave element according to preferred embodiments of the present invention will be explained. First, an Al thin film of about 100 nm to about 400 nm in thickness is formed on the piezoelectric substrate 3 using, for example, a vapor deposition method or a sputtering method, and thereafter, the thin film is patterned in a predetermined shape using photolithography and etching so as to form the IDTs and reflectors of longitudinally coupled double mode surface acoustic wave filters 4 and 5, and to form the input electrode 6, the output electrode 7, and the ground electrodes 8 defining electrode pads. Then, the intermediate electrodes 12 about 200 nm in thickness made of NiCr are formed on the input electrode 6, the output electrode 7, and the ground electrodes 8 by, for example, vapor deposition using a lift-off method, or other suitable method, and sputtering, and thereafter. the upper electrodes 11 about 1 µm in thickness made of A1 are formed on the intermediate electrodes 12 by vapor deposition, sputtering, or other suitable process, in the same manner as described above. The Au bumps 10 are formed on the thus formed upper electrodes 11 preferably using a ball bonding method. Specifically, a ball formed at the tip of an Au wire is adhered by pressing on the upper electrode 11 while an ultrasonic wave is being applied, and thereafter, the Au wire is cut off from the ball part to form the Au bump 10.

The surface of the surface acoustic wave element formed by way of the aforementioned processes is arranged to face the electrode patterns 9a and 9b formed on the package 9 with the Au bumps 10 therebetween, and the element is pressed while an ultrasonic wave and heat are being applied so as to connect them. Then, the package 9 is sealed airtight with the cap so as to complete the surface acoustic wave apparatus 1.

Table 1 shows results of examinations of layer thicknesses of the intermediate electrodes 12 and rates of occurrence of cracks occurring in the piezoelectric substrate. At this time, conditions of the examined surface acoustic wave apparatuses were that electrode pads and element electrodes were about 350 nm of A1 electrodes, intermediate electrodes were NiCr electrodes, upper electrodes were about 1 µm of A1 electrodes, and the other specifications were the same as those of the surface acoustic wave apparatus 1 shown in Fig. 2. The number examined was less than 150 when the layer thicknesses of intermediate electrodes were about 400 nm and about 500 nm, because items that were determined to be defective before the examinations of cracks were rejected.

**TABLE 1**

| Thickness of Intermediate electrode [nm] | Number of cracks occurring / Number of Examination | Rate of cracks occurrence |
|---|---|---|
| 10 | 7/200 | 3.5% |
| 50 | 6/200 | 3.0% |
| 100 | 0/200 | 0.0% |
| 150 | 0/150 | 0.0% |
| 200 | 0/200 | 0.0% |
| 250 | 0/150 | 0.0% |
| 300 | 0/150 | 0.0% |
| 400 | 0/149 | 0.0% |
| 500 | 0/148 | 0.0% |

As is clearly shown in Table 1, there is a decreasing tendency in the rate of defective items with increasing layer thickness of the intermediate electrode. That is, the stress relating to the piezoelectric substrate can be decreased by increasing the layer thickness. Since the rate of defective items is preferably less than about 3%, the layer thickness of the intermediate electrode preferably exceeds about 50 nm as shown in Table 1.

It is clear as shown in Table 1 that when the layer thickness of the intermediate electrode is about 100 nm or more, the cracking in the piezoelectric substrate can be prevented from occurring. Although it is clearly shown in Table 1 that the rate of defective items decreases with increasing layer thickness of the intermediate electrode, since more cost and time are required with increasing layer thickness, it is considered best that the layer thickness of the intermediate electrode be about 200 nm.

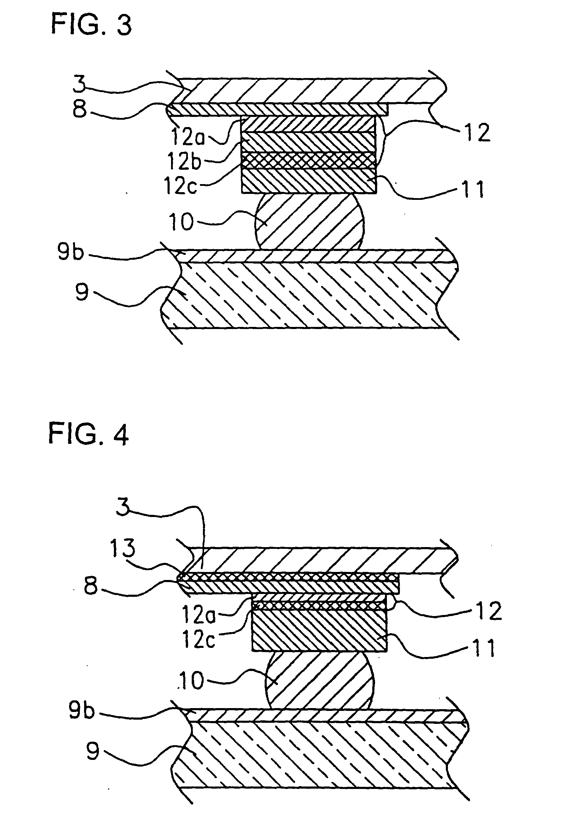

A second preferred embodiment according to the present invention will be explained with reference to Fig. 3. Fig. 3 is an enlarged sectional view of a mounting part via a metallic bump on a package of a surface acoustic wave apparatus according to the second preferred embodiment. Herein, the same elements as in the first preferred embodiment according to the present invention as shown in Figs. 1 and 2, are indicated by the same reference numerals as in the first preferred embodiment. and detail explanations thereof are omitted.

When the present preferred embodiment is compared with the first preferred embodiment, there is a difference in that while the intermediate electrode according to the first preferred embodiment is a monolayer electrode of about 200 nm in thickness made of NiCr, the intermediate electrode according to the present preferred embodiment is a multilayer electrode including a plurality of layers.

As shown in Fig. 3, an intermediate electrode 12 between a ground electrode 8 disposed on a piezoelectric substrate 3 and an upper electrode 11 has a three-layered structure. That is, the intermediate electrode preferably includes a NiCr layer 12a of about 50 nm in thickness, an A1 layer 12b of about 1 µm in thickness, and a Ti layer 12c of about 50 nm in thickness, in order from the piezoelectric substrate 3 side. Although not shown in the drawing, the other ground electrodes, an input electrode, and an output electrode have constitutions similar to the constitution as shown in Fig. 3.

In the present preferred embodiment, the thickness of the intermediate electrode 12 is preferably about 1100 nm. The cracking in the piezoelectric substrate 3 cannot be prevented from occurring even when the thickness of the entirety of the intermediate electrode 12 becomes about 100 nm or more as a result of increasing the layer thickness, in the intermediate electrode 12, made of the same kind of metal as the ground electrode 8 and the upper electrode 11 being electrode pads. Therefore, the total thickness of the NiCr layer 12a and the Ti layer 12c preferably exceeds about 50 nm, and is preferably specifically about 100 nm in this preferred embodiment.

By the aforementioned structure, the dispersion of the stress at boundaries of layers is reliably achieved, so that the cracking and the fracturing in the piezoelectric substrate are prevented from occurring.

A third preferred embodiment according to the present invention will be explained with reference to Fig. 4. Fig. 4 is an enlarged sectional view of a mounting portion joined via a metallic bump on a package of a surface acoustic wave apparatus according to the third preferred embodiment. Herein, the same elements as in the first preferred embodiment according to the present invention as shown in Figs. 1 and 2, and in the second preferred embodiment according to the present invention as shown in Fig. 3, are indicated by the same reference numerals as in the first and second preferred embodiments, and detailed explanations thereof are omitted.

When the present preferred embodiment is compared with the second preferred embodiment, there are points that a substrate electrode 13 is disposed between a ground electrode 8 defining an electrode pad and a piezoelectric substrate 3, and the Al layer 12b in the intermediate electrode 12 in the second preferred embodiment is not provided.

As shown in Fig. 4, an intermediate electrode 12 between the ground electrode 8 disposed on the piezoelectric substrate 3 and an upper electrode 11 has a two-layered structure. That is. the intermediate electrode preferably includes a NiCr layer 12a of about 50 nm in thickness and a Ti layer 12c of about 50 nm in thickness, in order from the piezoelectric substrate 3 side. By the aforementioned structure, the dispersion of the stress at boundaries of layers is made possible. so that the cracking and the fracturing in the piezoelectric substrate can be prevented from occurring.

As shown in Fig. 4, the substrate electrode 13 of about 10 nm in thickness made of Ti is disposed between the piezoelectric substrate 3 and the ground electrode 8 defining an electrode pad. By this substrate electrode 13, an adhesive strength of the piezoelectric substrate 3 and the ground electrode 8 defining an electrode pad is greatly improved, and electrical characteristics of a surface acoustic wave element are greatly improved. Although not shown in the drawing, the other ground electrodes, an input electrode, and an output electrode have constitutions similar to the constitution as shown in Fig. 4.

In the aforementioned first to third preferred embodiments, explanations were made using the piezoelectric substrate made of lithium tantalate as an element substrate. However, insulating substrates provided with a lithium niobate or zinc oxide film, and piezoelectric substrates, such as quartz and langasite, and other suitable substrates may be used and can exhibit similar effects.

In the aforementioned first to third preferred embodiments of the present invention, the element electrodes and the electrode pads, and the upper electrodes are preferably defined by Al electrodes. However, similar effects can be exhibited by alloying metallic materials such as an alloy made of Al and 5% of added Cu, and Au. Other suitable materials may also be used.

Furthermore, in the aforementioned first to third preferred embodiments, explanations were made of the electronic component apparatuses, as examples, in which the electronic elements are mounted facedown in the packages. However, the present invention can be applied in the case in which electronic elements are directly mounted facedown on circuit substrates or other suitable substrates.

In the aforementioned first to third preferred embodiments, explanations were made of NiCr and Ti as examples of the intermediate electrodes. However, any metals except metals constituting electrode pads or upper electrodes can be used, and in the case in which an electrode pad and an upper electrode include Al, in consideration of an adhesiveness, Ni, Cr, Ti, and NiCr are preferable.

In the aforementioned first to third preferred embodiments, explanations were made of the Au bump formed using the ball bonding as an example. However, for example, a bump forming method by plating may be used. The bump itself may be a metallic bump such as an A1 bump. In consideration of ease of manufacture, however, the Au bump formed using the ball bonding is preferable.

In the aforementioned third preferred embodiment, explanations were made of the substrate electrode made of Ti as an example. However, Cu, Cr, or other suitable materials, may be used as the substrate electrode, and the thickness thereof is not limited to about 10 nm as long as an adhesive strength of the piezoelectric substrate and the electrode pad can be improved.

In the aforementioned first to third preferred embodiments, the ultrasonic wave and heat are preferably applied at the same time for the facedown mounting. However, a method applying heat only or an ultrasonic wave only may be used. In the case in which the method of applying an ultrasonic wave is used, in particular, since a stress is likely to occur, the constitution of various preferred embodiments of the present invention is suitable for a facedown mounting using a method applying at least an ultrasonic wave.

Preferred embodiments of the present invention can be successfully applied to a communications apparatus. As shown in Fig. 5, a communications apparatus according to another preferred embodiment of the present invention preferably includes an antenna 30, a duplexer 31 connected to the antenna 30, a transmitting circuit and a receiving circuit both of which are connected to the duplexer 30. The transmitting circuit includes an inter-stage filter 34 to filter a signal that is generated at a oscillator 33 and divided by a divider 32, a power amplifier to amplify a transmitting signal and an isolator 36 to prevent a receiving signal from transmitting to a transmitting circuit. The receiving circuit includes a low-noise amplifier 37 to amplify a receiving signal from the antenna 30 and an inter-stage filter 38 to filter the receiving signal. An IF signal is output from a mixer 39 by mixing the receiving signal and the local signal.

While preferred embodiments of the invention have been disclosed, various modes of carrying out the principles disclosed herein are contemplated as being within the scope of the following claims. Therefore, it is understood that the scope of the present invention is not to be limited except as otherwise set forth in the claims.

## Claims

1. An electronic element (2) adapted for a facedown mounting, comprising:
a substrate (3);
an element electrode disposed on said substrate;
an electrode pad (6-8) connected to said element electrode;
a metallic bump (10);
an upper electrode (11) disposed on said electrode pad (6-8) and connected to said metallic bump (10); and
an intermediate electrode (12) located between said electrode pad and said upper electrode;
wherein said intermediate electrode includes a layer (12) made of a metal other than a metal constituting said electrode pad (6-8) or said upper electrode (11), and a thickness of said intermediate electrode is greater than about 50 nm.

2. An electrode element according to claim 1, wherein the intermediate electrode consists of a single layer (12) made of a metal other than a metal constituting said electrode pad or said upper electrode.

3. An electrode element according to claim 1, wherein said intermediate electrode includes a plurality of layers (12a,12b,12c) made of a metal other than a metal constituting said electrode pad or said upper electrode, and a total thickness of said plurality of layers is greater than about 50 nm.

4. An electrode element according to claim 1, wherein said intermediate electrode includes a plurality of layers, and a total thickness of said plurality of layers is greater than about 50 nm. except for layers made of a metal that is the same as a metal constituting one of said electrode pad and said upper electrode.

5. An electronic element according to claim 1, 2, 3 or 4, wherein the thickness of said intermediate electrode (12) is equal to or greater than about 100 nm.

6. An electronic element according to any previous claim, wherein the metal constituting at least one of said electrode pad (6-8) and said upper electrode (11) is Al, and said intermediate electrode (12) is made of a metal selected from the group consisting of Ni, Cr, NiCr, and Ti.

7. An electronic element according to any previous claim, wherein said metallic bump (10) is made of one of Au and a metallic material containing Au as a primary component.

8. An electronic element according to any previous claim, wherein said element electrode includes a plurality of layers and at least one (13) of said plurality of layers of said element electrode is provided between said electrode pad and said substrate (3).

9. An electronic element according to any previous claim, wherein said electronic element is a surface acoustic wave element.

10. An electronic part apparatus (1) comprising an electronic element (2) according to any previous claim, further comprising a package (9), wherein the electronic element (2) is mounted in the package in a facedown arrangement.

11. A communications device comprising an electronic element according to any one of claims 1-10.

12. A method of manufacturing an electronic component apparatus comprising the steps of:
forming an electronic element (2) including:
providing a substrate (3);
forming an element electrode on said substrate;
forming an electrode pad (6-8) connected to said element electrode;
forming an upper electrode (11) on said electrode pad;
connecting said upper electrode (11) to a metallic bump (10);
forming an intermediate electrode (12) between said electrode pad (6-8) and said upper electrode (11);
wherein said intermediate electrode (12) includes a layer made of a metal other than a metal constituting said electrode pad or said upper electrode, and a thickness of said intermediate electrode is greater than about 50 nm;
providing a housing (9); and
mounting said electronic element (2) in said housing (9) via a facedown mounting process.

13. A method according to claim 12, wherein said intermediate electrode consists of a single layer (12) made of a metal other than a metal constituting said electrode pad or said upper electrode.

14. A method according to claim 12. wherein said intermediate electrode includes a plurality of layers (12a,12b,12c) made of a metal other than a metal constituting said electrode pad or said upper electrode, and a total thickness of said plurality of layers is greater than about 50 nm.

15. A method according to claim 12, wherein said intermediate electrode includes a plurality of layers (12a,12b,12c), and a total thickness of said plurality of layers is greater than about 50 nm, except for layers made of a metal that is the same as a metal constituting one of said electrode pad and said upper electrode

16. A method according to any one of claims 12, 13, 14 or 15, further comprising the step of applying an ultrasonic wave during said step of mounting said electronic element (2) in said housing (9).
